# EUROPÄISCHE PATENTANMELDUNG

(11) **EP 1 465 254 A1**
(43) Veröffentlichungstag der Anmeldung: **06.10.2004**
(21) Anmeldenummer: 03007529.5
(22) Anmeldetag: 01.04.2003
(51) Int. Cl.: H01L 23/544, H01L 23/528, G06F 11/00

(54) **Halbleiter-Chip mit einer Identifikationsnummer-Generierungseinheit**

(71) Anmelder: Infineon Technologies AG, 81669 München (DE)
(72) Erfinder: Wagner, Wolfgang, 81539 München (DE)
(74) Vertreter: Repkow, Ines, Dr. Dipl.-Ing.

(57) **Zusammenfassung**

Es wird ein Halbleiter-Chip mit einer Identifikationsnummer-Generierungseinheit zur Generierung einer bestimmte Informationen über den Halbleiter-Chip enthaltenden Identifikationsnummer beschrieben. Der beschriebene Halbleiter-Chip zeichnet sich dadurch aus, daß die Identifikationsnummer-Generierungseinheit über mehrere Schichten des Halbleiter-Chips verteilt ist. Dadurch läßt sich die Identifikationsnummer schneller und einfacher ändern als es bisher der Fall ist.

## Beschreibung

Die vorliegende Erfindung betrifft eine Vorrichtung gemäß dem Oberbegriff des Patentanspruchs 1, d.h. einen Halbleiter-Chip mit einer Identifikationsnummer-Generierungseinheit zur Generierung einer bestimmte Informationen über den Halbleiter-Chip enthaltenden Identifikationsnummer.

Identifikationsnummer-Generierungseinheiten sind vor allem in Halbleiter-Chips, die eine digitale integrierte Schaltung enthalten, häufig anzutreffen. Die Identifikationsnummern können beispielsweise Informationen über den Hersteller des Halbleiter-Chips, und/oder über den Halbleiter-Chip-Typ, und/oder über die Design-Variante, und/oder über Einzelheiten der Herstellung des Halbleiter-Chips (Herstellungsort, Herstellungszeitpunkt, Nummer der Charge, aus welcher der Halbleiter-Chip stammt, etc.) umfassen.

Bei sogenannten Embedded Systems haben teilweise sogar einzelne Module einer auf einem Halbleiter-Chip untergebrachten integrierten Schaltung ihre eigenen Identifikationsnummern.

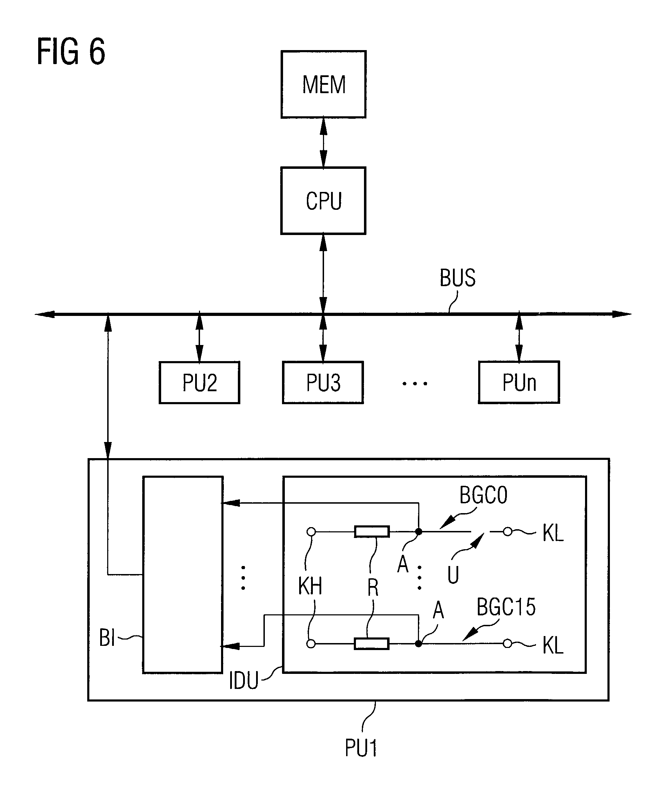

Ein möglicher Aufbau einer Anordnung zur Erzeugung und Weiterleitung einer Identifikationsnummer ist in Figur 6 veranschaulicht. Die Figur 6 zeigt die vorliegend interessierenden Bestandteile einer programmgesteuerten Einheit, beispielsweise eines Mikroprozessors, eines Mikrocontrollers, oder eines Signalprozessors. Es sei jedoch bereits an dieser Stelle darauf hingewiesen, daß Identifikationsnummern nicht nur bei programmgesteuerten Einheiten vorgesehen werden können, sondern auch bei beliebigen anderen integrierten Schaltungen.

Die in der Figur 6 gezeigte programmgesteuerte Einheit enthält eine CPU CPU, eine mit der CPU verbundene Speichereinrichtung MEM, und mit der CPU über einen Bus BUS verbundene Peripherieeinheiten PU1 bis PUn. Die Peripherieeinheiten PU1 bis PUn können beispielsweise einen A/D-Wandler, einen D/A-Wandler, einen DMA-Controller, einen Timer, etc. umfassen.

Im betrachteten Beispiel wird die Peripherieeinheit PU1 durch eine im folgenden als ID-Einheit bezeichnete Einrichtung zur Erzeugung und Weiterleitung einer Identifikationsnummer gebildet.

Die ID-Einheit enthält eine die Identifikationsnummer erzeugende Identifikationsnummer-Generierungseinheit IDU und ein Bus-Interface BI.

Die Identifikationsnummer-Generierungseinheit IDU ist beispielsweise in der Poly-Schicht oder in der Metall-Schicht des Halbleiter-Chips ausgebildet und enthält pro Bit der zu erzeugenden Identifikationsnummer eine Bitgenerierungsschaltung BGCx, wobei jede dieser Bitgenerierungsschaltungen BGCx ein bestimmtes Bit der Identifikationsnummer erzeugt.

Jede der Bitgenerierungsschaltungen BGCx besteht aus einer elektrischen Leitung, welche
- zwischen einem mit hohem elektrischen Potential (beispielsweise VDD) beaufschlagten Knoten KH und einem mit niedrigem elektrischen Potential (beispielsweise VSS) beaufschlagten Knoten KL verläuft,
- einen Abgriffspunkt A aufweist, an welchem das durch die betreffende Bitgenerierungsschaltungen BGCx erzeugte Identifikationsnummer-Bit abgegriffen wird,
- zwischen dem Abgriffspunkt A und einem der Knoten KH und KL einen Widerstand R enthält, und
- zwischen dem Abgriffspunkt A und dem anderen Knoten eine Unterbrechung U oder keine Unterbrechung U aufweist.

Die durch die Identifikationsnummer-Generierungseinheit IDU zu erzeugende Identifikationsnummer umfaßt eine Vielzahl von Bits. Im betrachteten Beispiel sind es 16 Bits, wobei die Anzahl der Bits jedoch auch beliebig viel größer oder kleiner sein kann. Bei einer 16 Bits umfassenden Identifikationsnummer müssen 16 Bitgenerierungsschaltungen BGCx, genauer gesagt Bitgenerierungsschaltungen BGC0 bis BGC15 mit dem vorstehend beschriebenen Aufbau vorgesehen werden. Von diesen 16 Bitgenerierungsschaltungen sind in der Figur 6 der Übersichtlichkeit halber nur zwei Bitgenerierungsschaltungen, nämlich die Bitgenerierungsschaltungen BGC0 und BGC15 dargestellt, und zwar eine Bitgenerierungsschaltung mit einer Unterbrechung U (Bitgenerierungsschaltung BGC0) und eine Bitgenerierungsschaltung ohne eine Unterbrechung U (Bitgenerierungsschaltung BGC15).

Bei Bitgenerierungsschaltungen mit einer Unterbrechung U wird der Abgriffspunkt A auf das hohe Potential VDD gezogen, und bei Bitgenerierungsschaltungen ohne eine Unterbrechung U auf das niedrige Potential VSS (oder umgekehrt).

Die Abgriffspunkte A aller Bitgenerierungsschaltungen BGC0 bis BGC15 sind mit dem Bus-Interface BI verbunden. Dem Bus-Interface BI ist über den Bus BUS befehlbar, die Identifikationsnummer auf den Bus auszugeben. Wenn das Bus-Interface ein solches Kommando erhält, gibt sie die an den Abgriffspunkten A der Bitgenerierungsschaltungen BGC0 bis BGC15 abgegriffenen Potentiale als Identifikationsnummer auf den Bus BUS aus.

Der Wert der Identifikationsnummer kann während der Herstellung des Halbleiter-Chips durch das Vorsehen oder Nicht-Vorsehen der Unterbrechungen U festgelegt werden. Somit kann durch die Maske für die Identifikationsnummer-Generierungseinheit IDU enthaltende Schicht des Halbleiter-Chips die Identifikationsnummer eingestellt werden.

Eine derartige Einstellung der Identifikationsnummer weist den Nachteil auf, daß bei jeder Veränderung des Designs des Halbleiter-Chips, die eine Veränderung der Identifikationsnummer zur Folge haben soll, immer auch die Maske geändert werden muß, durch welche die Identifikationsnummer eingestellt wird, und zwar auch dann, wenn die eigentliche Design-Änderung gar keine Veränderung der Maske für die die Identifikationsnummer-Generierungseinheit IDU enthaltenden Schicht (beispielsweise der Poly-Schicht des Halbleiter-Chips) erfordern würde.

Der vorliegenden Erfindung liegt daher die Aufgabe zugrunde, den Halbleiter-Chip gemäß dem Oberbegriff des Patentanspruchs 1 derart weiterzubilden, daß sich die Festlegung und die Veränderung der Identifikationsnummer mit geringerem Aufwand realisieren läßt als es bisher der Fall ist.

Diese Aufgabe wird erfindungsgemäß durch den in Patentanspruch 1 beanspruchten Halbleiter-Chip gelöst.

Der erfindungsgemäße Halbleiter-Chip zeichnet sich dadurch aus, daß die Identifikationsnummer-Generierungseinheit über mehrere Schichten des Halbleiter-Chips verteilt ist.

Dadurch kann die Identifikationsnummer-Generierungseinheit so angeordnet werden,
- daß einerseits eine Veränderung des Layouts von nur einer der Schichten, über welche die Identifikationsnummer-Generierungseinheit (IDU) verteilt ist, ausreicht, um die Identifikationsnummer zu verändern, und
- daß andererseits die Schichten, über welche die Identifikationsnummer-Generierungseinheit verteilt ist, mehrere Schichten umfassen, deren Veränderung eine Veränderung der Identifikationsnummer bewirken kann.

Dadurch kann vermieden werden, daß bei einer Veränderung des Designs des Halbleiter-Chips, die eine Veränderung der Identifikationsnummer erfordert, auch Schichten des Halbleiter-Chips verändert werden müssen, deren Veränderung für die eigentliche Design-Änderung überhaupt nicht erforderlich ist.

Vorteilhafte Weiterbildungen der Erfindung sind den Unteransprüchen, der folgenden Beschreibung, und den Figuren zu entnehmen. Es zeigen
- Figur 1: einen Halbleiter-Chip mit einer Identifikationsnummer-Generierungseinheit, deren Bitgenerierungsschaltungen zumindest teilweise in unterschiedlichen Schichten des Halbleiter-Chips vorgesehen sind,
- Figur 2: den Aufbau und die Anordnung einer insbesondere zur Anordnung in einem Substrat oder einer Wanne geeigneten Bitgenerierungsschaltung,
- Figuren 3A und 3B: den Aufbau und die Anordnung einer anderen Bitgenerierungsschaltung,
- Figur 4: eine vorteilhafte Weiterbildung der in den Figuren 3A und 3B gezeigten Bitgenerierungsschaltung,
- Figur 5: eine vorteilhafte Weiterbildung der in der Figur 5 gezeigten Bitgenerierungsschaltung,
- Figur 6: eine herkömmliche Anordnung zur Erzeugung und Weiterleitung einer Identifikationsnummer in einem Halbleiter-Chip, und
- Figur 7: eine stark schematisierte Querschnittsansicht eines Halbleiter-Chips.

Die hier vorgestellte Neuerung betrifft insbesondere die Identifikationsnummer-Generierungseinheit eines Halbleiter-Chips, durch welche die Identifikationsnummer eines Halbleiter-Chips erzeugt wird. Die Weiterverarbeitung der Identifikationsnummer innerhalb des Halbleiter-Chips, insbesondere die Weiterleitung der Identifikationsnummer an die diese Nummer benötigenden oder anfordernden Chip-Komponenten kann unverändert bleiben, oder muß jedenfalls nicht verändert werden.

Die hier vorgestellte Identifikationsnummer-Generierungseinheit weist - wie auch die eingangs beschriebene herkömmliche Identifikationsnummer-Generierungseinheit - pro Bit der zu erzeugenden Identifikationsnummer eine Bitgenerierungsschaltung auf, wobei jede dieser Bitgenerierungsschaltungen ein bestimmtes Bit der Identifikationsnummer erzeugt.

Die Bitgenerierungsschaltungen der hier vorgestellten Identifikationsnummer-Generierungseinheit können, wie nachfolgend noch näher beschrieben wird, den selben Aufbau wie, oder einen anderen Aufbau als die Bitgenerierungsschaltungen der eingangs beschriebenen herkömmlichen Identifikationsnummer-Generierungseinheit haben.

Die Bitgenerierungsschaltungen der hier vorgestellten Identifikationsnummer-Generierungseinheit sind aber auf jeden Fall anders angeordnet als die Bitgenerierungsschaltungen der eingangs beschriebenen herkömmlichen Identifikationsnummer-Generierungseinheit: die hier vorgestellte Identifikationsnummer-Generierungseinheit ist über mehrere Ebenen bzw. Schichten des Halbleiter-Chips verteilt.

Genauer gesagt ist die Identifikationsnummer-Generierungseinheit so angeordnet,
- daß eine Veränderung des Layouts von nur einer der Schichten, über welche die Identifikationsnummer-Generierungseinheit verteilt ist, ausreicht, um die Identifikationsnummer zu verändern, und
- daß die Schichten, über welche die Identifikationsnummer-Generierungseinheit verteilt ist, mehrere Schichten umfassen, deren Veränderung eine Veränderung der Identifikationsnummer bewirken kann.

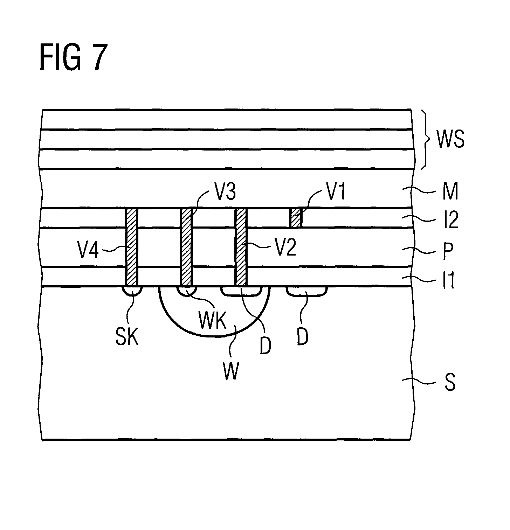

Bevor mit der Beschreibung begonnen wird, auf welche Art und Weise dies im einzelnen geschieht, wird zunächst unter Bezugnahme auf Figur 7 der prinzipielle Aufbau eines Halbleiter-Chips erläutert.

Die Figur 7 zeigt stark schematisiert einen vertikalen Querschnitt durch einen Halbleiter-Chip. Die Schraffuren sind der Übersichtlichkeit halber weggelassen. Der in der Figur 7 gezeigte Halbleiter-Chip besteht aus einem Substrat S, einer darüber angeordneten ersten Isolations-Schicht I1, einer über dieser angeordneten Polysilizium- bzw. Poly-Schicht P, einer darüber angeordneten zweiten Isolationsschicht I2, einer darüber angeordneten Metall-Schicht M, und darüber angeordneten weiteren Schichten WS zur Isolation, Passivierung, Kontaktierung etc.

Es sei angenommen, daß es sich beim Substrat S um ein p-Substrat handelt, und daß im Substrat eine oder mehrere n-Wannen W ausgebildet sind. In der Wanne W und außerhalb der Wanne W sind Diffusionsgebiete D ausgebildet, welche im Zusammenwirken mit in der Figur 7 nicht gezeigten Strukturen in der Poly-Schicht P und/oder in der Metall-Schicht M elektrische Bauelemente wie beispielsweise Transistoren bilden.

Weitere elektrische Bauelemente wie insbesondere Widerstände, Kondensatoren, Induktivitäten etc. werden durch entsprechende Strukturen in der Poly-Schicht P und/oder der Metall-Schicht M oder durch ein Zusammenwirken von in der Poly-Schicht P und der Metall-Schicht M vorhandenen Strukturen gebildet.

Zwischen der Metall-Schicht M und den Diffusionsgebieten D, und zwischen der Metall-Schicht M und der Poly-Schicht P verlaufen elektrische Verbindungen, über welche die im Halbleiter-Chip realisierten Bauelemente miteinander und/oder mit außerhalb des Halbleiter-Chips vorgesehenen Systemkomponenten verbunden sind. Diese Verbindungen sind in der Figur 7 mit den Bezugszeichen V1 und V2 bezeichnet.

Ferner sind zwischen der Metall-Schicht M und den Wannen W, genauer gesagt zwischen der Metall-Schicht M und in den Wannen W vorgesehenen Wannenkontakten WK, sowie zwischen der Metall-Schicht M und dem Substrat S, genauer gesagt zwischen der Metall-Schicht M und im Substrat S vorgesehenen Substratkontakten SK elektrische Verbindungen vorgesehen. Über diese, in der Figur 7 mit den Bezugszeichen V3 und V4 bezeichneten Verbindungen werden die Wannen W und das Substrat S auf für die ordnungsgemäße Funktion des Halbleiter-Chips erforderliche Potentiale gebracht.

Dies alles sowie die weiteren Einzelheiten des Aufbaus eines Halbleiter-Chips sind bekannt und bedürfen keiner näheren Erläuterung. Der Vollständigkeit halber sei jedoch darauf hingewiesen, daß der in der Figur 7 gezeigte Halbleiter-Chip-Aufbau nicht die einzige Möglichkeit für den Aufbau von Halbleiter-Chips darstellt. Es sind eine Vielzahl von Abwandlungen möglich. Beispielsweise ist es möglich, mehrere Poly-Schichten, mehrere Metall-Schichten, und/oder diverse weitere Modifikationen vorzusehen.

Eine erste Möglichkeit, die Identifikationsnummer-Generierungseinheit auf mehrere Schichten des Halbleiter-Chips zu verteilen, besteht darin, daß die Bitgenerierungsschaltungen der Identifikationsnummer-Generierungseinheit nicht mehr wie bisher alle in der selben Schicht des Halbleiter-Chips vorgesehen sind, sondern zumindest teilweise in unterschiedlichen Schichten des Halbleiter-Chips vorgesehen sind.

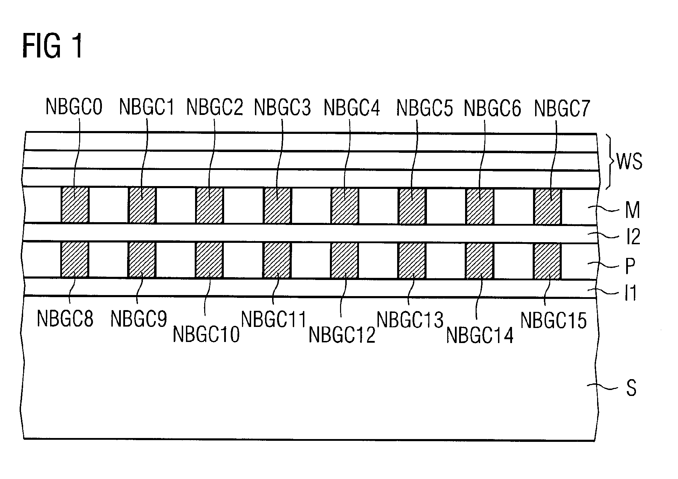

Ein Beispiel hierfür ist schematisch in Figur 1 veranschaulicht.

In der Figur 1 sind die Bitgenerierungsschaltungen mit den Bezugszeichen NBGC0 bis NBGC15 bezeichnet. Es sei angenommen, daß durch die Bitgenerierungsschaltung NBGC0 das Bit 0 der Identifikationsnummer festgelegt wird, durch die Bitgenerierungsschaltung NBGC1 das Bit 1 der Identifikationsnummer festgelegt wird, durch die Bitgenerierungsschaltung NBGC2 das Bit 2 der Identifikationsnummer festgelegt wird, ..., und durch die Bitgenerierungsschaltung NBGC15 das Bit 15 der Identifikationsnummer festgelegt wird.

Bei dem in der Figur 1 gezeigten Beispiel sind die die Bits 0 bis 7 der Identifikationsnummer bestimmenden Bitgenerierungsschaltungen NBGC0 bis NBGC7 in der Metall-Schicht M angeordnet, und die die Bits 8 bis 15 der Identifikationsnummer bestimmenden Bitgenerierungsschaltungen NBGC8 bis NBGC15 in der Poly-Schicht P angeordnet. Dadurch kann - anders als bei herkömmlichen Identifikationsnummer-Generierungseinheiten eine Veränderung der Identifikationsnummer sowohl durch eine Veränderung des Layout der Metall-Schicht M als auch durch eine Veränderung des Layout der Poly-Schicht P erfolgen.

Zur Vermeidung von Mißverständnissen sei angemerkt, daß die Bitgenerierungsschaltungen NBGC0 bis NBGC15 in der Figur 1 nur schematisch dargestellt sind.

Die Bitgenerierungsschaltungen NBGC0 bis NBGC15 können beispielsweise durch die Bitgenerierungsschaltungen BGC0 bis BGC15 der eingangs beschriebenen herkömmlichen Identifikationsnummer-Generierungseinheit IDU realisiert werden.

Die Bitgenerierungsschaltungen NBGC0 bis NBGC15 können aber auch einen beliebigen anderen Aufbau aufweisen. Sie könnten beispielsweise durch eine elektrische Leitung gebildet werden, welche
- zwischen einem mit hohem elektrischen Potential (beispielsweise VDD) beaufschlagten Knoten KH und einem mit niedrigem elektrischen Potential (beispielsweise VSS) beaufschlagten Knoten KL verläuft,
- einen Abgriffspunkt A aufweist, an welchem das durch die betreffende Bitgenerierungsschaltungen NBGCx erzeugte Identifikationsnummer-Bit abgegriffen wird, und
- die entweder zwischen dem Abgriffspunkt A und dem mit hohem elektrischen Potential beaufschlagten Knoten KH, oder zwischen dem Abgriffspunkt A und dem mit niedrigem elektrischen Potential beaufschlagten Knoten eine Unterbrechung U aufweist.

Die Bitgenerierungsschaltungen NBGC0 bis NBGC15 können unabhängig von deren Realisierung nicht nur in der Poly-Schicht P und der Metall-Schicht M des Halbleiter-Chips vorgesehen werden, sondern auch in anderen Schichten des Halbleiter-Chips, beispielsweise im Substrat S oder den darin vorgesehenen Wannen W. Obgleich es sich im allgemeinen als vorteilhaft erweisen dürfte, wenn möglichst viele verschiedene Schichten des Halbleiter-Chips eine oder mehrere Bitgenerierungsschaltungen NBGC0 bis NBGC15 enthalten, besteht keine zwingende Notwendigkeit, daß alle Schichten, die solche Bitgenerierungsschaltungen enthalten können, auch tatsächlich solche Bitgenerierungsschaltungen enthalten; die Bitgenerierungsschaltungen NBGC0 bis NBGC15 können auf beliebig viele und beliebig ausgewählte Schichten des Halbleiter-Chips verteilt werden.

Die Realisierung der Bitgenerierungsschaltungen NBGC0 bis NBGC15 im Substrat S bzw. den darin vorgesehenen Wannen W erfolgt durch entsprechend ausgebildete Diffusionsgebiete im Substrat S und/oder in den Wannen W. Hierbei muß gegebenenfalls durch geeignete Maßnahmen dafür gesorgt werden, daß kein Kurzschluß, kein Latch-Up-Effekt, und kein Substratsteuereffekt entsteht. Wodurch dies geschehen kann, ist bekannt und bedarf keiner näheren Erläuterung.

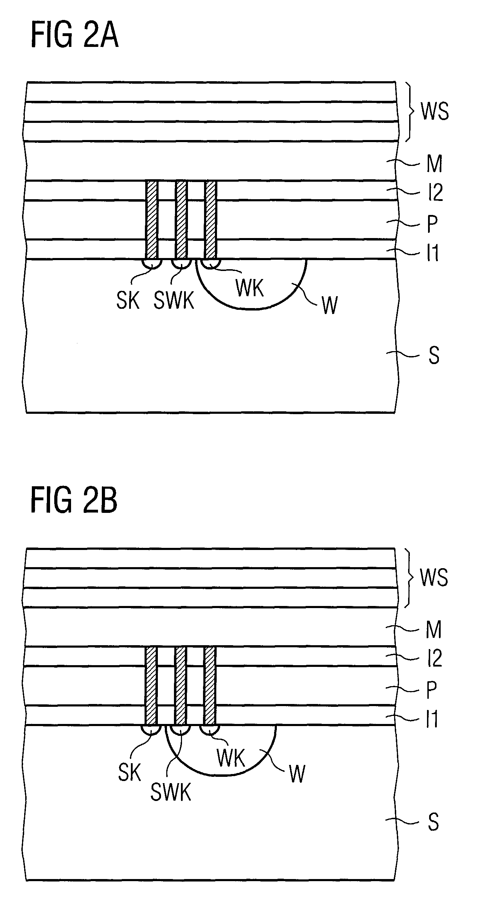

Im Substrat S oder in den Wannen W kann anstelle von wie vorstehend beschrieben ausgebildeten Bitgenerierungsschaltungen ein zwischen einem Substratkontakt SK und einem Wannenkontakt WK liegender Substrat/Wannenkontakt vorgesehen werden, und dieser Substrat/Wannenkontakt als Abgriff für das durch die betreffende Bitgenerierungsschaltung zu erzeugende Identifikationsnummer-Bit verwendet werden. Dies ist in den Figuren 2A und 2B veranschaulicht.

Die Figuren 2A und 2B zeigen ein Substrat S, eine darin ausgebildete Wanne W, einen im Substrat S vorgesehenen Substratkontakt SK, einen in der Wanne W vorgesehenen Wannenkontakt WK, und einen zwischen dem Substratkontakt SK und dem Wannenkontakt WK liegenden Substrat/Wannenkontakt SWK.

Bei dem in der Figur 2A gezeigten Aufbau befindet sich der Substrat/Wannenkontakt SWK außerhalb der Wanne W, so daß sich an diesem das an den Substratkontakt SK angelegte Potential einstellt, und bei dem in der Figur 2B gezeigten Aufbau befindet sich der Substrat/Wannenkontakt SWK innerhalb der Wanne W, so daß sich an diesem das an den Wannenkontakt WK angelegte Potential einstellt. Da an den Substratkontakt SK und den Wannenkontakt WK unterschiedlich hohe Potentiale angelegt werden (beispielsweise VSS an Substratkontakt, und VDD an Wannenkontakt, oder umgekehrt), kann auf das sich am Substrat/Wannenkontakt SWK einstellende Potential durch eine Variierung der Wannengröße Einfluß genommen werden: die Ausbildung einer großen Wanne, genauer gesagt die Ausbildung einer Wanne, die so groß ist, daß sich der Substrat/Wannenkontakt SWK innerhalb der Wanne befindet, bewirkt, daß am Substrat/Wannenkontakt SWK das Potential VDD abgegriffen wird, und die Ausbildung einer kleinen Wanne, genauer gesagt die Ausbildung einer Wanne, die so klein ist, daß sich der Substrat/Wannenkontakt SWK außerhalb der Wanne befindet, bewirkt, daß am Substrat/Wannenkontakt SWK das Potential VSS abgegriffen wird. Somit kann durch eine Variierung der Größe der im Substrat S vorgesehenen Wannen die Identifikationsnummer verändert werden. Eine Veränderung der Identifikationsnummer kann auch durch eine Veränderung der Lage der Wanne W erfolgen.

Eine weitere Möglichkeit, die Identifikationsnummer-Generierungseinheit über mehrere Schichten des Halbleiter-Chips zu verteilen, besteht darin, daß pro Bit der Identifikationsnummer mehrere Bitgenerierungsschaltungen und eine Logikschaltung vorgesehen sind, wobei
- die mehreren Bitgenerierungsschaltungen in verschiedenen Schichten des Halbleiter-Chips angeordnet sind,
- die Logikschaltung eine logische Verknüpfung der an den Abgriffspunkten der Bitgenerierungsschaltungen abgegriffenen Signale durchführt, und
- das Ausgangssignal der Logikschaltung als das zu erzeugende Bit der Identifikationsnummer verwendet wird.

Die mehreren Bitgenerierungsschaltungen können durch die vorstehend beschriebenen Bitgenerierungsschaltungen oder durch beliebige andere Bitgenerierungsschaltungen wie beispielsweise die im folgenden beschriebenen Bitgenerierungsschaltungen gebildet werden. Die mehreren Bitgenerierungsschaltungen müssen nicht identische Bitgenerierungsschaltungen sein, sondern können auch verschiedenen Bitgenerierungsschaltungs-Typen umfassen.

Eine weitere Möglichkeit, die Identifikationsnummer-Generierungseinheit über mehrere Schichten des Halbleiter-Chips zu verteilen, besteht darin, einzelne, mehrere, oder alle Bitgenerierungsschaltungen so anzuordnen, daß sich diese über mehrere Schichten des Halbleiter-Chips erstrecken, wobei vorzugsweise in mehreren oder allen durchlaufenen Schichten Möglichkeiten zur Einflußnahme auf das von der jeweiligen Bitgenerierungsschaltung erzeugte Identifikationsnummer-Bit existieren, aber bereits die Veränderung einer dieser Schichten ausreicht, um das Identifikationsnummer-Bit zu verändern.

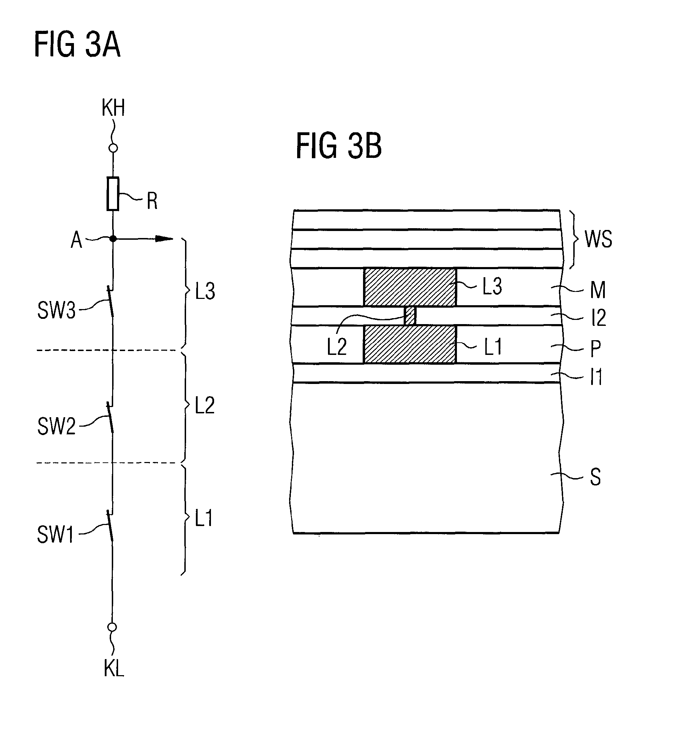

Ein Beispiel für eine solche Bitgenerierungsschaltung ist in den Figuren 3A und 3B gezeigt, wobei Figur 3A das zugrundeliegende Prinzip, und die Figur 3B eine Möglichkeit der praktischen Realisierung zeigen.

Gemäß Figur 3A kann eine solche Bitgenerierungsschaltung als elektrische Leitung angesehen werden, die
- zwischen einem mit hohem elektrischen Potential (beispielsweise VDD) beaufschlagten Knoten KH und einem mit niedrigem elektrischen Potential (beispielsweise VSS) beaufschlagten Knoten KL verläuft,
- einen Abgriffspunkt A aufweist, an welchem das durch die betreffende Bitgenerierungsschaltung erzeugte Identifikationsnummer-Bit abgegriffen wird,
- zwischen dem Abgriffspunkt A und einem der Knoten KH und KL ein Widerstand R enthält, und
- zwischen dem Abgriffspunkt A und dem anderen der Knoten KH und KL drei in Reihe geschaltete Schalter SW1 bis SW3 enthält.

Der den Schalter SW1 enthaltende Leitungsabschnitt wird im folgenden als L1 bezeichnet, der den Schalter SW2 enthaltende Leitungsabschnitt wird im folgenden als L2 bezeichnet, und der den Schalter SW3 enthaltende Leitungsabschnitt wird im folgenden als L3 bezeichnet.

Die Schalter SW1 bis SW3 repräsentieren das Vorhandensein einer Unterbrechung im betreffenden Leitungsabschnitt oder das Fehlen des betreffenden Leitungsabschnittes (geöffneter Schalter) bzw. das Nicht-Vorhandensein einer Unterbrechung im betreffenden Leitungsabschnitt (geschlossener Schalter). Bei der später beschriebenen praktischen Realisierung der in der Figur 3A gezeigten Anordnung werden also keine Schalter realisiert, sondern "nur" die Verbindungen bzw. Unterbrechungen, die sich bei den gewünschten Schalterstellungen ergeben. Die Stellung der Schalter wird bei der Herstellung des Halbleiter-Chips durch das Layout festgelegt und kann danach nicht mehr bzw. nur durch eine Layout-Änderung verändert werden.

Es sei angenommen, daß der Leitungsabschnitt L1 durch eine in der Poly-Schicht vorgesehene Struktur gebildet wird, daß der Leitungsabschnitt L2 durch eine in der Isolier-Schicht I2 vorgesehene Struktur gebildet wird, und daß der Leitungsabschnitt L3 durch eine in der Metall-Schicht M vorgesehene Struktur gebildet wird. Die den Leitungsabschnitt L2 bildende Struktur in der Isolier-Schicht I2 wird durch eine Durchkontaktierung von der Metall-Schicht M zur Poly-Schicht P realisiert. Wie später noch besser verstanden werden wird, können die einzelnen Leitungsabschnitte auch durch entsprechende Strukturen in anderen Schichten des Halbleiter-Chips realisiert werden. In Frage kommen alle Schichten, die elektrisch leitende Strukturen enthalten können.

Zur Vermeidung von Mißverständnissen sei angemerkt, daß die Stellungen der Schalter SW1 bis SW3 unabhängig voneinander festgelegt werden können.

Die in der Figur 3A gezeigte Bitgenerierungsschaltung läßt sich wie in der Figur 3B gezeigt realisieren.

Weil im betrachteten Beispiel die Schalter SW1 bis SW3 geschlossen sind,
- sind die Leitungsabschnitte L1 bis L3 vorhanden und weisen keine Unterbrechung auf, und
- stellt sich am Abgriffspunkt A das am Knoten KL anliegende niedrige Potential ein.

Wären ein oder mehrere der Schalter SW1 bis SW3 geöffnet, so würden die die geöffneten Schalter enthaltenden Leitungsabschnitte eine Unterbrechung aufweisen oder wären überhaupt nicht vorhanden. Genauer gesagt ist es so,
- daß ein geöffneter Schalter SW1 durch Weglassen der den Leitungsabschnitt L1 bildenden Struktur in der Poly-Schicht P, oder durch Vorsehen einer Unterbrechung in dieser Struktur realisiert wird, so daß keine Verbindung zwischen dem Knoten KL und dem Leitungsabschnitt L2 besteht,
- daß ein geöffneter Schalter SW2 durch Weglassen der den Leitungsabschnitt L2 bildenden Struktur in der Isolations-Schicht 12, also durch ein Weglassen der Durchkontaktierung von der Metall-Schicht M zur Poly-Schicht P realisiert wird, so daß keine Verbindung zwischen dem Leitungsabschnitt L1 und dem Leitungsabschnitt L3 besteht,
- daß ein geöffneter Schalter SW3 durch Weglassen der den Leitungsabschnitt L1 bildenden Struktur in der Metall-Schicht M, oder durch Vorsehen einer Unterbrechung in dieser Struktur realisiert wird, so daß keine Verbindung zwischen dem Leitungsabschnitt L2 und dem Abgriffspunkt A besteht.

Wären ein oder mehrere der Schalter SW1 bis SW3 geöffnet, so würde sich am Abgriffspunkt A das am Knoten KH anliegende hohe Potential einstellen.

Ausgehend von dem in den Figuren 3A und 3B gezeigten Zustand kann also sowohl durch eine dem Öffnen des Schalters SW1 entsprechende Modifikation der Poly-Schicht P, als auch durch eine dem Öffnen des Schalters SW2 entsprechende Modifikation der Isolations-Schicht I2, als auch durch eine dem Öffnen des Schalters SW3 entsprechende Modifikation der Metall-Schicht M erreicht werden, daß das durch die Bitgenerierungsschaltung erzeugte Identifikationsnummer-Bit seinen Wert ändert.

In welchen Schichten die Knoten KL und KH, der Abgriffspunkt A, und der Widerstand R vorgesehen sind, spielt keine Rolle. Die betreffenden Komponenten sind daher in der Figur 3B nicht gezeigt.

Bei dem in den Figuren 3A und 3B gezeigten Beispiel der Bitgenerierungsschaltung sind die Schalter SW1 bis SW3 normale Ein/Ausschalter. Hierbei kann es vorkommen, daß die Veränderung der Stellung eines bestimmten Schalters, genauer gesagt die Realisierung der veränderten Schalterstellung in der Bitgenerierungsschaltung keine Veränderung des von der Bitgenerierungsschaltung erzeugten Identifikationsnummer-Bits zur Folge hat.

Dieses Problem tritt nicht oder zumindest weniger ausgeprägt auf, wenn in der Bitgenerierungsschaltung anstelle von Ein/Ausschaltern Umschalter und/oder Kreuzschalter, genauer gesagt die Verbindungen bzw. Unterbrechungen realisiert werden, die sich bei den gewünschten Stellungen dieser Schalter ergeben. Es sei bereits an dieser Stelle darauf hingewiesen, daß in der Bitgenerierungsschaltung auch beliebige Kombinationen von Ein/Ausschaltern, Umschaltern und/oder Kreuzschaltern, genauer gesagt die Verbindungen bzw. Unterbrechungen realisiert werden, die sich bei den gewünschten Stellungen dieser Schalter ergeben.

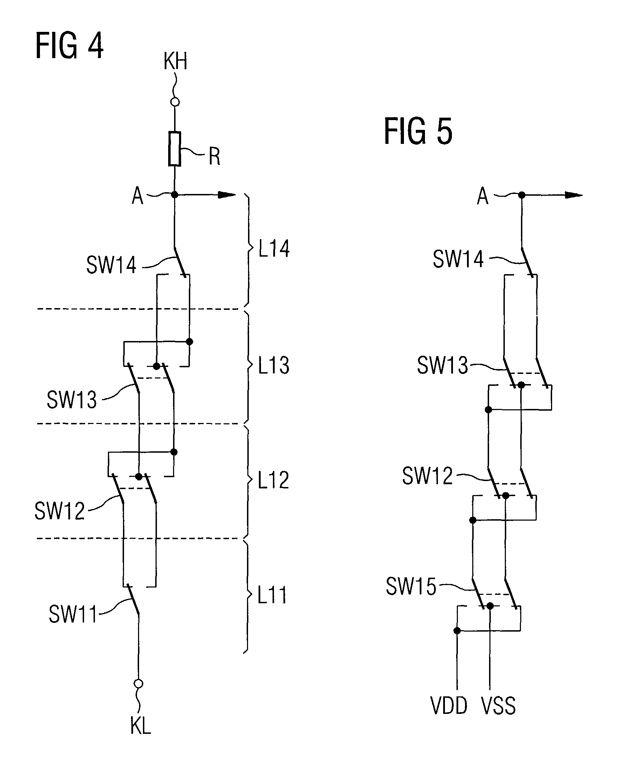

Das grundlegende Prinzip einer solchen Bitgenerierungsschaltung ist in Figur 4 veranschaulicht.

Gemäß Figur 4 kann eine solche Bitgenerierungsschaltung als elektrische Leitung angesehen werden, die
- zwischen einem mit hohem elektrischen Potential (beispielsweise VDD) beaufschlagten Knoten KH und einem mit niedrigem elektrischen Potential (beispielsweise VSS) beaufschlagten Knoten KL verläuft,
- einen Abgriffspunkt A aufweist, an welchem das durch die betreffende Bitgenerierungsschaltung erzeugte Identifikationsnummer-Bit abgegriffen wird,
- zwischen dem Abgriffspunkt A und einem der Knoten KH und KL ein Widerstand R enthält, und
- zwischen dem Abgriffspunkt A und dem anderen der Knoten KH und KL vier in Reihe geschaltete Schalter SW11 bis SW14 enthält, wobei die Schalter SW11 und SW14 Umschalter sind, und die Schalter SW12 und SW13 Kreuzschalter sind.

Der den Schalter SW11 enthaltende Leitungsabschnitt wird im folgenden als L11 bezeichnet, der den Schalter SW12 enthaltende Leitungsabschnitt wird im folgenden als L12 bezeichnet, der den Schalter SW13 enthaltende Leitungsabschnitt wird im folgenden als L3 bezeichnet, und der den Schalter SW14 enthaltende Leitungsabschnitt wird im folgenden als L14 bezeichnet. Jeder der Leitungsabschnitte L11 bis L14 besteht genau genommen aus mehreren Leitungsteilen. Die jeweils mehreren Leitungsteile werden im folgenden aber dennoch als ein Leitungsabschnitt bezeichnet.

Die Schalter SW11 bis SW14 repräsentieren das Vorhandensein oder Fehlen von Verbindungen bzw. Unterbrechungen im betreffenden Leitungsabschnitt sowie die Position der Verbindungen bzw. Unterbrechungen innerhalb des betreffenden Leitungsabschnittes. Wie bei der in den Figuren 3A und 3B veranschaulichten Ausführungsform der Bitgenerierungsschaltung werden auch bei dieser Ausführungsform der Bitgenerierungsschaltung keine Schalter realisiert, sondern "nur" die Verbindungen bzw. Unterbrechungen, die sich bei den gewünschten Schalterstellungen ergeben. Die Stellung der Schalter wird bei der Herstellung des Halbleiter-Chips durch das Layout festgelegt und kann danach nicht mehr bzw. nur durch eine Layout-Änderung verändert werden.

Es sei angenommen, daß der Leitungsabschnitt L11 durch eine im Substrat S oder in einer Wanne W vorgesehene Struktur, gebildet wird, daß der Leitungsabschnitt L12 durch eine in der Poly-Schicht P vorgesehene Struktur gebildet wird, daß der Leitungsabschnitt L13 durch eine in der Isolations-Schicht I2 vorgesehene Struktur gebildet wird, und daß der Leitungsabschnitt L14 durch eine in der Metall-Schicht M vorgesehene Struktur gebildet wird. Die den Leitungsabschnitt L13 bildende Struktur in der Isolier-Schicht I2 wird durch eine Durchkontaktierung von der Metall-Schicht M zur Poly-Schicht P realisiert. Die einzelnen Leitungsabschnitte könnten auch durch entsprechende Strukturen in anderen Schichten des Halbleiter-Chips realisiert werden. In Frage kommen alle Schichten, die elektrisch leitende Strukturen enthalten können.

Zur Vermeidung von Mißverständnissen sei angemerkt, daß die Stellungen der Schalter SW11 bis SW14 unabhängig voneinander festgelegt werden können.

Die praktische Realisierung der in der Figur 4 gezeigten Anordnung erfolgt ähnlich wie die praktische Realisierung der in der Figur 3A gezeigte Anordnung. Unterschiedlich ist nur, daß aufgrund der anderen Schaltertypen, die in der Anordnung gemäß Figur 4 vorgesehen sind, und der damit verbundenen Änderungen in den Leitungsabschnitten, entsprechend veränderte Strukturen zur Realisierung dieser Leitungsabschnitte in den Halbleiter-Chip-Schichten vorzusehen sind. Die praktische Realisierung dieser veränderten Strukturen bereitet keine Schwierigkeiten: der prinzipielle Aufbau dieser Strukturen ist aus der Figur 4 ermittelbar, und Möglichkeiten zur praktischen Realisierung solcher Strukturen wurden in der auf die Figuren 3A und 3B bezugnehmenden Beschreibung aufgezeigt.

Erwähnenswert in diesem Zusammenhang ist lediglich, daß die im Substrat S oder den Wannen W vorzusehenden Strukturen durch Ausbildung entsprechender Diffusionsgebiete im Substrat S und/oder den Wannen W realisierbar sind.

Wie aus der Figur 4 unschwer zu erkennen ist, kann sowohl durch eine dem Umschalten des Schalters SW11 entsprechende Modifikation der Diffusionsgebiete im Substrat S und/oder den Wannen W, als auch durch eine dem Umschalten des Schalters SW12 entsprechende Modifikation der Poly-Schicht P, als auch durch eine dem Umschalten des Schalters SW13 entsprechende Modifikation der Isolations-Schicht I2, als auch durch eine dem Umschalten des Schalters SW14 entsprechende Modifikation der Metall-Schicht M erreicht werden, daß das durch die Bitgenerierungsschaltung erzeugte Identifikationsnummer-Bit seinen Wert ändert.

Ersetzt man den durch einen Umschalter gebildeten Schalter SW11 durch einen Kreuzschalter, und legt an den einen der zwei Eingangsanschlüsse dieses Schalters ein niedriges Potential (beispielsweise VSS), und an den anderen der zwei Eingangsanschlüsse dieses Schalters ein hohes Potential (beispielsweise VDD), so läßt sich die Anordnung noch einfacher realisieren als es ohnehin schon der Fall ist. Bei einer so realisierten Bitgenerierungsschaltung kann nämlich der Widerstand R entfallen.

Eine solche Bitgenerierungsschaltung ist in Figur 5 veranschaulicht. Der Kreuzschalter, der den Umschalter SW11 ersetzt, ist mit dem Bezugszeichen SW15 bezeichnet.

Weitere Vorteile lassen sich erzielen, wenn auch der Umschalter SW14 durch einen Kreuzschalter ersetzt wird. In diesem Fall würde die Anordnung zwei Abgriffe aufweisen, an welchen komplementäre Signale ausgegeben werden und folglich - durch Auswahl des einen Ausgangssignals als Identifikationsnummer-Bit oder des anderen Ausgangssignals als Identifikationsnummer-Bit eine weitere Möglichkeit besteht, die Identifikationsnummer zu verändern.

Der Vollständigkeit halber sei angemerkt, daß in den Bitgenerierungsschaltungen prinzipiell die Schalterstellungen beliebig vieler und beliebig ausgebildeter Schalter realisiert werden können, und daß die Bitgenerierungsschaltungen unabhängig voneinander auf beliebig viele und beliebig ausgewählte Halbleiter-Chip-Schichten verteilt sein können.

Es dürfte einleuchten, daß die Erzeugung der einzelnen Identifikationsnummer-Bits unabhängig voneinander unter Verwendung beliebiger Bitgenerierungsschaltungen erzeugt werden können. Insbesondere können die vorstehend beschriebenen Möglichkeiten zur Identifikationsnummer-Bit-Erzeugung beliebig kombiniert werden, und es besteht keine zwingende Notwendigkeit, daß alle Bits der Identifikationsnummer nach einer der vorstehend beschriebenen Möglichkeiten erzeugt werden.

Der beschriebene Halbleiter-Chip, genauer gesagt die darin enthaltene Identifikationsnummer-Generierungseinheit, ermöglicht es unabhängig von den Einzelheiten der praktischen Realisierung, die Festlegung der Identifikationsnummer unter allen Umständen schnell und einfach zu ändern.

### Bezugszeichenliste

- A: Abgriffspunkt
- BGCx: Bitgenerierungsschaltung
- BI: Bus-Interface
- BUS: Bus
- CPU: CPU
- D: Diffusionsgebiet
- Ix: Isolations-Schicht
- IDU: Identifikationsnummer-Generierungseinheit
- KH: Knoten
- KL: Knoten
- Lx: Leitungsabschnitt
- M: Metall-Schicht
- MEM: Speichereinrichtung
- NBGCx: Bitgenerierungsschaltung
- P: Poly-Schicht
- PUx: Peripherieeinheiten
- R: Widerstand
- S: Substrat
- SK: Substratkontakt
- SWx: Schalter
- SWK: Substrat/Wannenkontakt
- U: Unterbrechung
- Vx: Verbindung
- W: Wanne
- WK: Wannenkontakt
- WS: Halbleiter-Chip-Schichten

## Patentansprüche

1. Halbleiter-Chip mit einer Identifikationsnummer-Generierungseinheit (IDU) zur Generierung einer bestimmte Informationen über den Halbleiter-Chip enthaltenden Identifikationsnummer,
**dadurch gekennzeichnet,**
**daß** die Identifikationsnummer-Generierungseinheit (IDU) über mehrere Schichten (S; I1, P, I2, M, WS) des Halbleiter-Chips verteilt ist.

2. Halbleiter-Chip nach Anspruch 1,
**dadurch gekennzeichnet,**
**daß** die Identifikationsnummer Informationen über den Hersteller des Halbleiter-Chips, und/oder über den Halbleiter-Chip-Typ, und/oder über die Design-Variante, und/oder über Einzelheiten der Herstellung des Halbleiter-Chips umfassen.

3. Halbleiter-Chip nach Anspruch 1,
**dadurch gekennzeichnet,**
**daß** die Identifikationsnummer-Generierungseinheit (IDU) so angeordnet ist,
- **daß** eine Veränderung des Layouts von nur einer der Schichten (S; I1, P, I2, M, WS), über welche die Identifikationsnummer-Generierungseinheit (IDU) verteilt ist, ausreicht, um die Identifikationsnummer zu verändern, und
- **daß** die Schichten (S; I1, P, I2, M, WS), über welche die Identifikationsnummer-Generierungseinheit (IDU) verteilt ist, mehrere Schichten umfassen, deren Veränderung eine Veränderung der Identifikationsnummer bewirken kann.

4. Halbleiter-Chip nach Anspruch 1,
**dadurch gekennzeichnet,**
**daß** die Identifikationsnummer-Generierungseinheit (IDU) pro Bit der zu erzeugenden Identifikationsnummer eine Bitgenerierungsschaltung (BGC0-BGC15; NBGC0-NBGC15) enthält, wobei jede Bitgenerierungsschaltung (BGC0-BGC15; NBGC0-NBGC15) ein bestimmtes Bit der Identifikationsnummer erzeugt.

5. Halbleiter-Chip nach Anspruch 4,
**dadurch gekennzeichnet,**
**daß** die Bitgenerierungsschaltungen (BGC0-BGC15; NBGC0-NBGC15) zumindest teilweise jeweils eine oder mehrere elektrische Leitungen umfassen, und daß der Wert des von der betreffenden Bitgenerierungsschaltung erzeugten Identifikationsnummer-Bits von der Anzahl und/oder der Position von in den Leitungen dieser Bitgenerierungsschaltung vorhandenen Verbindungen und/oder Unterbrechungen abhängt.

6. Halbleiter-Chip nach Anspruch 5,
**dadurch gekennzeichnet,**
**daß** die Bitgenerierungsschaltungen (BGC0-BGC15; NBGC0-NBGC15) zumindest teilweise einen Abschnitt enthalten, durch welchen ein in einer bestimmten Stellung befindlicher Ein/Aus-Schalter nachgebildet wird.

7. Halbleiter-Chip nach Anspruch 5,
**dadurch gekennzeichnet,**
**daß** die Bitgenerierungsschaltungen (BGC0-BGC15; NBGC0-NBGC15) zumindest teilweise einen Abschnitt enthalten, durch welchen ein in einer bestimmten Stellung befindlicher Umschalter nachgebildet wird.

8. Halbleiter-Chip nach Anspruch 5,
**dadurch gekennzeichnet,**
**daß** die Bitgenerierungsschaltungen (BGC0-BGC15; NBGC0-NBGC15) zumindest teilweise einen Abschnitt enthalten, durch welchen ein in einer bestimmten Stellung befindlicher Kreuzschalter nachgebildet wird.

9. Halbleiter-Chip nach Anspruch 4,
**dadurch gekennzeichnet,**
- **daß** der Halbleiter-Chip ein Substrat (S) mit mindestens einer darin ausgebildeten Wanne (W) aufweist,
- **daß** das Substrat (S) über einen Substratkontakt (SK) mit einem ersten Potential beaufschlagt wird, und die Wanne (W) über einen Wannenkontakt (WK) mit einem zweiten Potential beaufschlagt wird, und
- **daß** die Bitgenerierungsschaltungen (BGC0-BGC15; NBGC0-NBGC15) zumindest teilweise durch einen zwischen dem Substratkontakt (SK) und dem Wannenkontakt (WK) angeordneten Substrat/Wannenkontakt (SWK) gebildet werden.

10. Halbleiter-Chip nach Anspruch 9,
**dadurch gekennzeichnet,**
**daß** der Wert des von der Bitgenerierungsschaltung (BGCO-BGC15; NBGC0-NBGC15) erzeugten Identifikationsnummer-Bits davon abhängt, ob der Substrat/Wannenkontakt (SWK) innerhalb oder außerhalb der Wanne (W) liegt.

11. Halbleiter-Chip nach Anspruch 10,
**dadurch gekennzeichnet,**
**daß** der Wert des von der Bitgenerierungsschaltung (BGCO-BGC15; NBGC0-NBGC15) erzeugten Identifikationsnummer-Bits durch eine Veränderung der Größe und/oder der Lage der Wanne (W) veränderbar ist.

12. Halbleiter-Chip nach Anspruch 4,
**dadurch gekennzeichnet,**
**daß** die einzelnen Bitgenerierungsschaltungen (BGC0-BGC15; NBGC0-NBGC15) zumindest teilweise in unterschiedlichen Schichten (S; I1, P, I2, M, WS) des Halbleiter-Chips vorgesehen sind.

13. Halbleiter-Chip nach Anspruch 4,
**dadurch gekennzeichnet,**
**daß** sich die einzelnen Bitgenerierungsschaltungen (BGCO-BGC15; NBGC0-NBGC15) zumindest teilweise über mehrere Schichten (S; I1, P, I2, M, WS) des Halbleiter-Chips erstrecken.

14. Halbleiter-Chip nach Anspruch 13,
**dadurch gekennzeichnet,**
**daß** in mehreren oder allen Schichten (S; I1, P, I2, M, WS), über welche sich eine einzelne Bitgenerierungsschaltung (BGC0-BGC15; NBGC0-NBGC15) erstreckt, eine oder mehrere Möglichkeiten zur Einflußnahme auf das von der betreffenden Bitgenerierungsschaltung erzeugte Identifikationsnummer-Bit existieren, aber bereits die Veränderung einer dieser Schichten ausreicht, um das Identifikationsnummer-Bit zu verändern.

15. Halbleiter-Chip nach Anspruch 1,
**dadurch gekennzeichnet,**
**daß** die Identifikationsnummer-Generierungseinheit (IDU) pro Bit der zu erzeugenden Identifikationsnummer mehrere Bitgenerierungsschaltungen (BGC0-BGC15; NBGC0-NBGC15) und eine Logikschaltung enthalten, wobei
- die mehreren Bitgenerierungsschaltungen in verschiedenen Schichten des Halbleiter-Chips angeordnet sind,
- die Logikschaltung eine logische Verknüpfung der an den Abgriffspunkten der Bitgenerierungsschaltungen abgegriffenen Signale durchführt, und
- das Ausgangssignal der Logikschaltung als das zu erzeugende Bit der Identifikationsnummer verwendet wird.
